# EUROPEAN PATENT APPLICATION

(11) **EP 2 523 232 A1**
(43) Date of publication of application: **14.11.2012**
(21) Application number: 12167361.0
(22) Date of filing: 09.05.2012
(51) Int. Cl.: H01L 51/56, H01L 51/00

(54) **Method for manufacturing organic EL device, manufacturing apparatus for organic EL device, and organic EL device**

(30) Priority: 13.05.2011 JP 2011108456
(71) Applicant: Nitto Denko Corporation, Osaka 567-8680 (JP)
(72) Inventor: Nakai, Takahiro, Osaka, Ibaraki 567-8680 (JP); Morita, Shigenori, Osaka, Ibaraki 567-8680 (JP); Nagase, Junichi, Osaka, Ibaraki 567-8680 (JP); Neghishi, Nobukazu, Osaka, Ibaraki 567-8680 (JP); Ichieda, Naoko, Osaka, Ibaraki 567-8680 (JP); Hosokawa, Kazuto, Osaka, Ibaraki 567-8680 (JP)
(74) Representative: Stolmár Scheele & Partner

(57) **Abstract**

A method for manufacturing an organic EL device, including: while supplying a strip-shaped substrate (21), forming an organic EL film (19) on the substrate (21) by successively vapor depositing at least an organic layer including a light-emitting layer (25a) and an electrode layer (27) on one side of the substrate (21); and successively winding up the substrate (21) on which the organic EL film (19) is formed by the vapor deposition, wherein the substrate (21) is wound up along with a strip-shaped protective film (30) that is softer than the substrate (21) while supplying the protective film (30) and adhering the protective film to a non-vapor deposition side of the substrate (21).

## Description

### BACKGROUND OF THE INVENTION

### Field of the Invention

The present invention relates to a method for manufacturing an organic EL device, in which electrode layers and an organic EL film having an organic layer are formed on a substrate, and which is configured to emit light from the organic layer, and a manufacturing apparatus therefor, and the organic EL device.

### Description of the Related Art

Recently, organic EL (electroluminescence) devices have been drawing attention as devices that can be used in next-generation, low-power-consumption, light-emitting display devices. Basically, an organic EL device has an organic layer, which includes a light-emitting layer formed from an organic light-emitting material, and a pair of electrodes. Since such an organic EL device can emit light in various colors derived from the organic light-emitting material and is a self light-emitting device, organic EL devices are attracting attention for display applications such as in televisions (TVs).

Such an organic EL device is configured from a substrate and an organic EL film. The organic EL film is configured so that the organic layer is sandwiched between two electrode layers that have opposite polarities relative to each other (a sandwich configuration). The organic layer sandwiched by the electrode layers is supported on the substrate, and the organic EL device is formed by laminating an anode layer, the organic layer, and a cathode layer in that order on the substrate.

In such a method for manufacturing an organic EL device, commonly known methods for depositing (forming) the organic layer and the cathode layer on the anode layer formed on the substrate include a vacuum vapor deposition method and a coating method. Among these, the vacuum vapor deposition method is mainly used, especially because the purity of the material for forming the organic layer (organic layer forming material) can be increased, and because a long life can be obtained.

In the above-described vacuum vapor deposition method, the organic layer and the cathode layer are formed by carrying out vapor deposition on the substrate using a vapor deposition apparatus that includes a vacuum chamber and vapor deposition sources that are respectively arranged in the vacuum chamber corresponding to the organic layer and the cathode layer. Specifically, an organic layer forming material and a cathode layer forming material are heated by a heating unit that is arranged in each vapor deposition source, whereby these materials are vaporized. The vaporized organic layer forming material and cathode layer forming material (vaporized materials) are discharged from the respective vapor deposition sources, whereby an organic layer is vapor deposited on the anode layer formed on the substrate and a cathode layer is vapor deposited on the organic layer.

In this vacuum vapor deposition method, a so-called batch process or roll process is employed. The batch process is a process in which an organic layer and a cathode layer are vapor deposited onto an anode layer for each individual substrate on which the anode layer is formed. The roll process is a process in which an organic layer and a cathode layer are continuously formed on an anode layer while continuously feeding a strip-shaped substrate on which the anode layer is formed and which is wound up in a roll shape, and supporting the fed substrate with the surface of a can roll, so that the substrate moves with the rotation of the can roll, and the substrate on which an organic EL film has thus been formed is wound up in a roll shape. Of these, from the perspective of reducing costs, it is preferable to manufacture the organic EL device using a roll process.

However, when a roll process is employed in a vacuum vapor deposition method, during recovery of the substrate on which the organic EL film is formed by winding it up in a roll shape, the organic EL film formed on the substrate and the side on which an organic EL film is not formed on the substrate (the non-vapor deposition side) rub against each other. Since the surface of the substrate generally has fine uneven portions, the rubbing between the substrate and the organic EL film damages the organic EL film, which can cause leaks or light emission defects, and can even cause the yield deteriorate.

Accordingly, a technology has been proposed that prevents damage to an organic EL film by, when recovering a substrate on which the organic EL film is formed by winding it up in a roll shape, winding up the substrate while arranging a protective film between the organic EL film on the previously wound-up substrate and the non-vapor deposition face of the substrate to be subsequently wound up (refer to Patent Document 1)

Patent Document 1: Japanese Patent Application Laid-Open No. 2006-294536

### SUMMARY OF THE INVENTION

However, merely arranging a protective film between the organic EL film on the previously wound-up substrate and the non-vapor deposition side of the substrate to be subsequently wound up can cause the protective film to become misaligned with respect to the organic EL film due to protective film being wound up while sandwiched between the organic EL film and the non-vapor deposition side of the substrate. Further, since the protective and the organic EL film rub against each other because of this misalignment, the organic EL film may be damaged despite the fact that a protective film is arranged between the organic EL film and the non-vapor deposition side of the substrate.

Accordingly, one technique to prevent damage to the organic EL film resulting from the above-described misalignment would be to adhere the protective film to the vapor deposition side of the substrate using a bonding-type adhesive. However, if the protective film is adhered to the vapor deposition side, the bonding-type adhesive may stick to the organic EL film, thereby damaging the organic EL film.

In addition, even if a protective film is arranged as described above, the organic EL film can still be damaged due to slight rubbing between the protective and the organic EL film caused by vibrations and the like.

It is an object of the present invention to, in view of the above-described problems, provide a method for manufacturing an organic EL device, which can wind up a substrate on which an organic EL film is formed while preventing damage to the organic EL film, a manufacturing apparatus therefor, and the organic EL device.

To solve the above-described problems, a method for manufacturing an organic EL device according to the present invention includes:
while supplying a strip-shaped substrate, forming an organic EL film on the substrate by successively vapor depositing at least an organic layer including a light-emitting layer and an electrode layer on one side of the substrate; and
successively winding up the substrate on which the organic EL film is formed by the vapor deposition, wherein
the substrate is wound up along with a strip-shaped protective film that is softer than the substrate while supplying the protective film and adhering the protective film to a non-vapor deposition side of the substrate.

According to this configuration, by winding up the substrate while adhering the protective film to the non-vapor deposition side of the substrate, a bonding-type adhesive and the like can be prevented from sticking to the organic EL film, and when the protective film is sandwiched between the non-vapor deposition side of the substrate and the organic EL film, the occurrence of misalignment of the protective film with respect to the organic EL film can be prevented. Consequently, while preventing damage to the organic EL film by preventing sticking of a bonding-type adhesive and the like, damage to the organic EL film can be prevented by reducing rubbing between the protective film and the organic EL film. Further, by using a protective film that is softer than the substrate, even if rubbing occurs to some extent between the organic EL film and the protective film, damage to the organic EL film due to contact with the protective film can be prevented. Therefore, the substrate on which the organic EL film is formed can be wound up while preventing damage to the organic EL film.

Further, in the method for manufacturing an organic EL device according to the present invention, it is preferable to, while supplying the substrate on which a first electrode layer is formed on one side, successively vapor deposit on the first electrode layer the organic layer and a second electrode layer which has an opposite polarity to the first electrode layer.

Still further, in the method for manufacturing an organic EL device according to the present invention, the protective film preferably has an elastic modulus of 4.2 GPa or less.

With such a configuration, damage to the organic EL film formed on the substrate can be more reliably prevented.

Moreover, in the method for manufacturing an organic EL device according to the present invention, the substrate is preferably formed from a metal material.

Such a configuration is more effective because the substrate on which the organic EL film is formed can be wound up while preventing damage to the organic EL film even when using a substrate that has especially large surface unevenness and is comparatively hard.

In addition, in the method for manufacturing an organic EL device according to the present invention, it is preferable that the protective film have on one side a pressure-sensitive adhesive layer that allows the protective film to be adhered to and peeled from the substrate, and that the protective film be adhered to a non-vapor deposition side of the substrate via the pressure-sensitive adhesive layer.

With such a configuration, misalignment between the protective film and the substrate can be prevented because the protective film can be adhered to and peeled from the substrate.

Further, a manufacturing apparatus for an organic EL device according to the present invention includes:
a vapor deposition part for, while a strip-shaped substrate is supplied, forming an organic EL film on the substrate by successively vapor depositing at least an organic layer including a light-emitting layer and an electrode layer on one side of the substrate;
a recovery part for successively winding up the substrate on which the organic EL film is formed by the vapor deposition part; and
a protective film supply part for supplying a strip-shaped protective film that is softer than the substrate, wherein
the recovery part is configured to wind up the substrate and the protective film while the protective film supplied from the protective film supply part is adhered to a non-vapor deposition side of the substrate.

Still further, in the manufacturing apparatus for an organic EL device according to the present invention, the vapor deposition part is preferably configured to, while the substrate on which a first electrode layer is formed on one side is supplied, successively vapor deposit on the first electrode layer the organic layer and a second electrode layer which has an opposite polarity the first electrode layer.

Moreover, an organic EL device according to the present invention includes:
a substrate;
an organic EL film provided on one side of the substrate, the organic EL film comprising a first electrode layer, an organic layer including a light-emitting layer, and a second electrode layer which has an opposite polarity to the first electrode layer; and
a protective film that is adhered to an opposite side to the organic EL film on the substrate and that is softer than the substrate.

Thus, according to the present invention, a substrate on which an organic EL film is formed can be wound up while preventing damage to the organic EL film.

According to another aspect of the present invention, there is provided a method for manufacturing an organic EL device including the steps of:
supplying a substrate which has a strip-shape;
forming an organic EL film on the substrate by successively vapor depositing an organic layer including a light-emitting layer and an electrode layer on one side of the substrate;
supplying a protective film which has a strip-shape and is softer than the substrate;
adhering the protective film to a non-vapor deposition side of the substrate; and
winding up the substrate to which the protective film has been adhered

### BRIEF DESCRIPTION OF THE DRAWINGS

FIG. 1 is a schematic lateral cross-section view schematically illustrating a manufacturing apparatus for an organic EL device according to an embodiment that is used in a method for manufacturing an organic EL device according to an embodiment of the present invention;
FIG. 2 is a schematic lateral cross-section view illustrating a region S indicated by the dashed line of FIG. 1 in an expanded manner;
FIG. 3 is a schematic lateral cross-section view schematically illustrating a state in which a plurality of vapor deposition sources are provided in a vacuum chamber;
FIG. 4A is a schematic lateral croas-section view schematically illustrating a layer structure of an organic EL device, which is formed with an organic EL film formed on one side of a substrate and a protective film adhered to the other side, in which there is one organic layer;
FIG. 4B is a schematic lateral cross-section view schematically illustrating a layer structure of an organic EL device, which is formed with an organic EL film formed on one side of a substrate and a protective film adhered to the other side, in which there are three organic layers; and
FIG. 4C is a schematic lateral cross-section view schematically illustrating a layer structure of an organic EL device, which is formed with an organic EL film formed on one side of a substrate and a protective film adhered to the other side, in which there are five organic layers.

### DETAILED DESCRIPTION OF THE PREFERRED EMBODIMENT

The method for manufacturing an organic EL device, the manufacturing apparatus for the organic EL device, and the organic EL device according to the present invention will now be described with reference to the drawings.

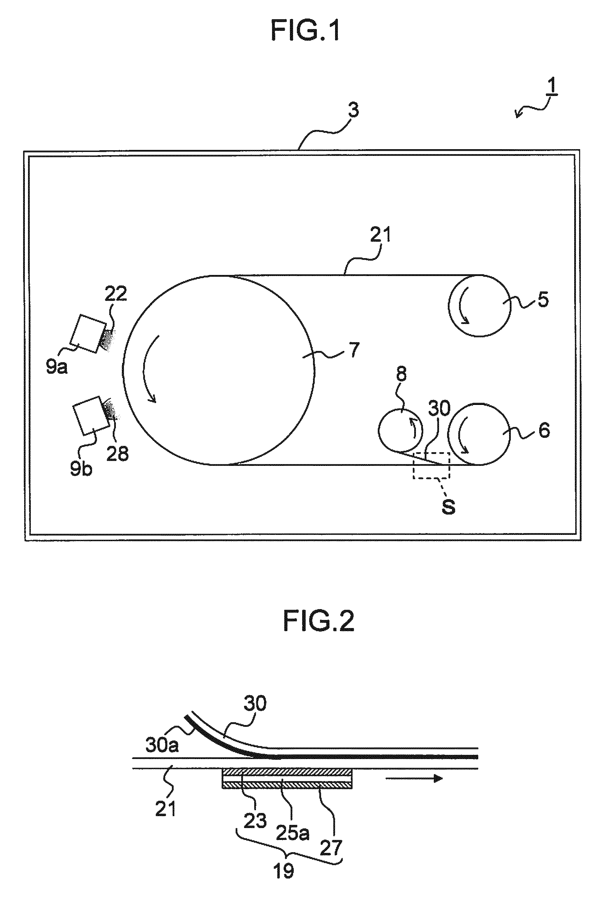

As illustrated in FIGS. 1 and 2, a manufacturing apparatus 1 for an organic EL device includes a substrate feeder 5, which is a substrate supply part that supplies a strip-shaped substrate 21, a can roll 7, which is a conveyance part that is rotatingly driven by the movement of the substrate 21 in contact with a non-vapor deposition side of the substrate 21 that is supplied from the substrate feeder 5, a vapor deposition source 9, which is a vapor deposition part that forms an organic EL film 19 on the substrate 21 by discharging a vaporized organic layer forming material 22 and a vaporized cathode layer forming material 28 onto an anode layer 23 formed on the substrate 21 that is held in contact with the can roll 7 to successively deposit an organic layer that includes a light-emitting layer and a cathode layer, a recovery unit 6, which is a recovery part that successively winds up the substrate 21 on which the organic EL film 19 has been formed by the vapor deposition source 9, and a protective film feeder 8, which is a protective film supply part that supplies a protective film 30. Further, the recovery unit 6 is configured so that the substrate 21 is wound up along with the protective film 30 while adhering the protective film 30 supplied from the protective film feeder 8 on the non-vapor deposition side of the substrate 21.

In addition, the manufacturing apparatus 1 also includes a vacuum chamber 3. In the vacuum chamber 3 are arranged the above-described substrate feeder 5, can roll 7, vapor deposition source 9 comprising a plurality of vapor deposition sources, protective feeder 8, and recovery unit 6. The vacuum chamber 3 is configured so that a vacuum region can be formed in its interior by reducing the pressure state in the interior by a non-illustrated vacuum generator.

As the substrate feeder 5, a substrate supply roller 5 is provided that feeds out the strip-shape substrate 21 wound up in a roll shape. As the recovery unit 6, a wind-up roller 6 is provided that winds up the fed substrate 21 along with the protective film 30. Specifically, the substrate 21 fed from the substrate supply roller 5 is supplied to the can roll 7, and then wound up by the wind-up roller 6.

In addition, as the protective film feeder 8, a protective film supply roller 8 is provided that feeds out the strip-shaped protective film 30 wound up in a roll shape. As described below, the substrate 21 is wound up on the wind-up roller 6 while the protective film 30 fed from the protective film supply roller 8 is adhered to the non-vapor deposition side of the substrate 21.

The can roll 7, which is formed from cylindric shaped stainless steel, is configured so that it can be rotatingly driven. This can roll 7 is arranged at a position where the substrate 21 that is fed (supplied) from the substrate supply roller 5 and wound up onto the wind-up roller 6 can be wound around the can roller 7 at a predetermined tension. Further, the can roll 7 is arranged so that the non-vapor deposition side of the substrate 21 (specifically, the opposite side to the side on which the anode layer is provided) is supported by the periphery (surface) of the can roll 7. When the can roll 7 rotates (rotates in an anticlockwise direction in FIG. 1), the can roll 7 can cause the wound (supported) substrate 21 to move in the rotational direction with the can roll 7.

This can roll 7 preferably has a temperature regulation mechanism, such as a cooling mechanism, in its interior. By having such a mechanism, during the below-described formation of the organic layer on the substrate 21, the temperature of the substrate 21 can be stabilized. The outer diameter of the can roll 7 can be set to, for example, 300 to 2,000 mm.

When the can roll 7 rotates, based on that rotation, the substrate 21 is successively fed from the substrate supply roller 5. The fed substrate 21 moves in the rotational direction of the can roll 7 while being in contact with and being supported on the periphery of the can roll 7, and the substrate 21 that has separated from the can roll 7 is wound up by the wind-up roller 6.

As the material forming the substrate 21, a material having sufficient flexibility so that it is not damaged even when wound on the can roll 7 may be used. Examples of such a material include metal materials and non-metal materials. Among these, the substrate 21 is preferably formed from a metal material. It is more effective to use a metal material because the substrate 21 on which the organic EL film 19 is formed can be wound up while preventing damage to the organic EL film 19 even when using a substrate 21 that has especially large surface unevenness and is comparatively hard.

Examples of the above-described metal material include stainless steel (SUS), iron (Fe), aluminum (Al) and the like. From the perspective of rigidity, the metal material is preferably stainless steel.

Examples of the above-described non-metal material include a glass film, polyethylene terephthalate (PET), polyethylene naphthalate (PEN) and the like. From the perspective of gas barrier properties, the non-metal material is preferably a glass film.

The anode layer 23 (see FIG. 2) is formed in advance on the surface of the substrate 21 by sputtering.

Examples of materials that can be used to form the anode layer 23 include indium-tin oxide (ITO), indium-zinc oxide (IZO), zinc oxide (ZnO), zinc oxide materials, such as gallium-doped zinc oxide (GZO) and antimony-doped zinc oxide (AZO) and the like.

In addition, if a material that can be vapor deposited from a vapor deposition source is used as the material for the anode layer 23, the anode layer 23 may be formed by arranging a vapor deposition source for the anode layer 23 in the vacuum chamber 3, and vapor depositing the anode layer 23 on the substrate 21.

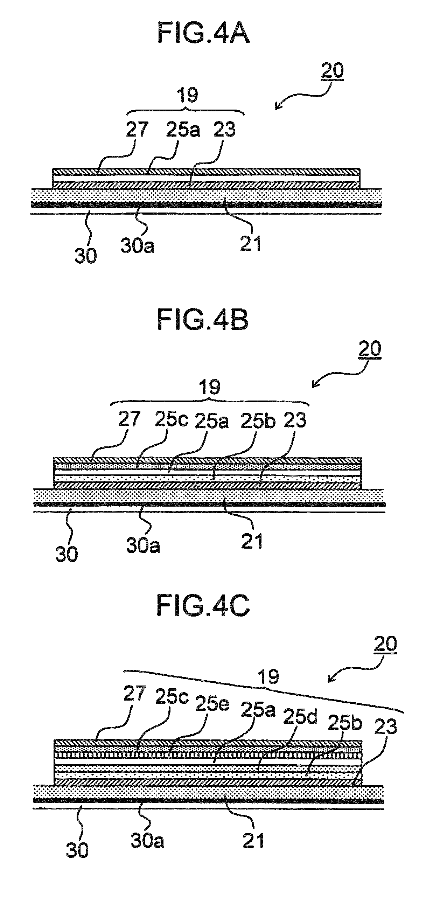

The vapor deposition source 9 is for forming an organic layer that includes a light-emitting layer 25a (see FIG. 2 and FIGS. 4A to 4C) and a cathode layer 27. The vapor deposition source 9 is configured from a first vapor deposition source 9a for forming the organic layer and a second vapor deposition source 9b for forming the cathode layer 27. One or more first vapor deposition sources 9a may be provided based on the organic layer to be formed. In the present embodiment, one first vapor deposition source 9a is provided for forming one tight-emitting layer 25a as the organic layer (see FIGS. 2 and 4A)

In addition, at a position facing a support region of the substrate 21 on the periphery of the can roll 7, the first vapor deposition source 9a is arranged on an upstream side in the movement direction of the substrate 21, and the second vapor deposition source 9b is arranged on a downstream side. Further, the first and second vapor deposition sources 9a and 9b are configured so that they can discharge vaporized organic layer forming material 22 and cathode layer forming material 28, respectively, toward the substrate 21 by heating, for example. The light-emitting layer 25a is formed on the anode layer 23 by vapor depositing the organic layer forming material 22 from the first vapor deposition source 9a on the anode layer 23 formed on the substrate 21 (see FIG. 2 and FIGS. 4A to 4C), and then the cathode layer 27 is formed on the light-emitting layer 25a by vapor depositing the cathode layer forming material 28 from the second vapor deposition source 9b on the fight-emitting layer 25a.

Thus, the organic EL film 19 having the anode layer 23, light-emitting layer 25a, and cathode layer 27 on the substrate 21 is formed by consecutively vapor depositing, in order, the light-emitting layer 25a and the cathode layer 27 on the anode layer 23 formed on the substrate 21, thereby forming an organic EL device 20.

The organic layer is configured from a single organic structural layer, or by laminating a plurality of organic structural layers. If the organic layer is configured from a single organic structural layer, this organic structural layer is the above-described light-emitting layer 25a. If the organic layer is configured from a plurality of organic structural layers, the plurality of organic structural layers consists of the light-emitting layer 25a and an organic structural layer other than the light-emitting layer 25a. Examples of organic structural layers other than the light-emitting layer 25a include a hole injection layer 25b, a hole transport layer 25d, an electron injection layer 25c, an electron transport layer 25e and the like.

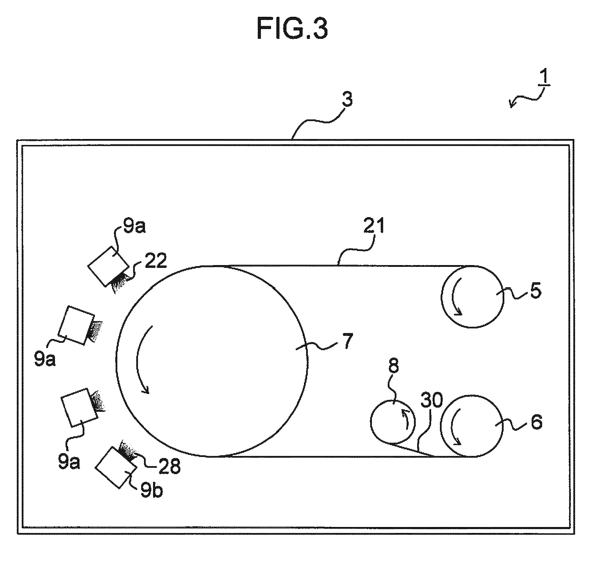

When the organic layer is a three-layer laminate, for example, as illustrated in FIG. 4B, three first vapor deposition sources 9a may be provided along the rotational direction of the can roll 7, as illustrated in FIG. 3. When a plurality of first vapor deposition sources 9a are thus provided along the rotational direction of the can roll 7, the laminate can be formed by vapor depositing a first organic structural layer on the anode layer 23 by the first vapor deposition source 9a arranged furthest upstream in the rotational direction, and then successively vapor depositing the second and subsequent organic structural layers on the first organic structural layer by the first vapor deposition sources 9a arranged downstream.

Thus, the organic layer is not especially limited, as long as it includes a light-emitting layer. The organic layer may optionally be configured so that it is formed by laminating a plurality of organic structural layers. For example, as illustrated in FIG. 4B, the organic layer may be a three-layer laminate formed by laminating the hole injection layer 25b, the light-emitting layer 25a, and the electron injection layer 25c in that order. In addition, optionally, the organic layer may be a four-layer laminate formed by sandwiching the hole transport layer 25d (see FIG. 4C) between the light-emitting layer 25a and the hole injection layer 25b, as illustrated in FIG. 4B, or sandwiching the electron transport layer 25e (see FIG. 4C) between the light-emitting layer 25a and the electron injection layer 25c.

Further, as illustrated in FIG. 4C, the organic layer may be a five-layer laminate formed by sandwiching the hole transport layer 25d between the hole injection layer 25b and the light-emitting layer 25a, and sandwiching the electron transport layer 25e between the light-emitting layer 25a and the electron injection layer 25c. Although the thickness of each layer is usually designed to be about several nm to several tens nm, the thickness is not especially limited, and may be designed as appropriate based on the organic layer forming material 22, the light-emitting properties and the like.

Examples of the material used to form the light-emitting layer 25a include tris(8-quinolmol)aluminum (Alq3), [2-tert-butyl-6-[2-(2,3,6,7-tetrahydro-1,1,1,7,7-tetramethyl-1H,5H-benzo[ij]quinolizin -9-yl)vinyl]-4H-pyran-4-ylidene] malononitrile (DCJTB) and the like.

Examples of the material used to form the hole injection layer 25b include copper phthalocyanine (CuPc), N,'-di(1-naphthyl)-N,N'-phenyl-1,1'-biphenyl-4,4'-diamine (α-NPD) and the like.

Examples of the material used to form the hole transport layer 25d include N,N'-di(l-naphthyl)-N, N'-diphenyl-1,1'-biphenyl-4,4-'diamine (α-NPD), N,N,N',N'-tetraphenyl-4,4'-diaminophenyl, N,N'-diphenyl-N,N'-bis(3-methylphenyl)-[1,1'-biphenyl]-4,4'diamine (TPD) and the like.

Examples of the material used to form the electron injection layer 25c include lithium fluoride (LiF), cesium fluoride (CsF) and the like.

Examples of the material used for the electron transport layer 25e include tris(8-quinoliol)aluminum (Alq3) and the like.

Examples of the material used to form the cathode layer 27 include aluminum (Al), magnesium silver (Mg/Ag), ITO, IZO and the like.

In the present embodiment, as illustrated in FIGS. 1 and 2, the wind-up roller 6 is configured to wind up the substrate 21 to have a side (vapor deposition side) of the substrate on which the organic EL film 19 is formed arranged on the external side, and the non-vapor deposition side arranged on the inner side. Further, the wind-up roller 6 is configured so that it winds up the substrate 21 along with the protective film 30 while the protective film 30 fed from the protective supply roller 8 is being adhered to the non-vapor deposition side of the substrate 21.

In addition, the protective film 30 fed from the protective film supply roller 8 is configured so as to be softer than the substrate 21, and thereby damaging or scratching on the organic EL film 19 as a result of the contact with the protective film 30 can be prevented. Further, the elastic modulus of the protective film 30 is not especially limited, as long as the protective film 30 is softer than the substrate 21. However, for example, the protective film 30 has an elastic modulus of preferably 4.2 GPa or less, and more preferably 4.0 GPa or less. By setting the elastic modulus to 4.2 GPa or less, damaging or scratching on the organic EL film 19 can be more reliably prevented.

In addition, a material that is smoother than the substrate 21 is preferred as the material for forming the protective film 30. By using such a material, damaging or scratching on the organic EL film 19 as a result of the contact with the protective film 30 can be better prevented. The protective film 30 preferably has a smoothness of, for example, a center line average roughness (Ra) of 2 nm or less, and a maximum height (Rmax) of 15 nm or less. With such values, since the protective film 30 is sufficiently smooth, damaging or scratching on the organic EL film 19 can be better prevented.

Examples of the material for forming such a protective film 30 include polyethylene terephthalate (PET), polyethylene naphthalate (PEN), polyimide (PI), polyethylene (PE), polypropylene (PP) and the like.

In the present embodiment, the protective film 30 is configured having on one side a pressure-sensitive adhesive layer 30a that can adhere to and peel away from the substrate 21. The pressure-sensitive adhesive layer 30a of the protective film 30 fed from the protective film supply roller 8 is configured to adhere to the non-vapor deposition side of the substrate 21. Specifically, the protective film 30 is configured so that it adheres to the non-vapor deposition side of the substrate 21 via the pressure-sensitive adhesive layer 30a.

Thus, the protective film 30 has on one side a pressure-sensitive adhesive layer 30a that can adhere to and be peeled away from the substrate 21. Accordingly, misalignment between the protective film 30 and the substrate 21 can be prevented by adhering the protective film 30 to the non-vapor deposition side of the substrate 21 via the pressure-sensitive adhesive layer 30a.

Examples of the material (pressure-sensitive adhesive) for forming this pressure-sensitive adhesive layer 30a include rubber, acrylic, and silicon pressure-sensitive adhesives, for example.

In addition, the pressure-sensitive adhesive layer 30a preferably has a peel strength of 5 N/m or more. With such a peel strength, peeling of the protective film 30 from the substrate 21 after it has been adhered to the substrate 21 can be prevented. Further, the pressure-sensitive adhesive layer 30a has a peel strength of preferably 100 N/m or less, and more preferably 60 N/m or less. Setting the peel strength of the pressure-sensitive adhesive layer 30a to 100 N/m or less prevents the peel strength from being too strong, and thereby deformation of the substrate 21 when the protective film 30 is peeled from the substrate 21 can be prevented.

The protective film 30 having on one side such a pressure-sensitive adhesive layer 30a can be formed by coating the protective film with a pressure-sensitive adhesive. This process can be carried out using, for example, a comma coater, a gravure coater, a slot die coater and the like.

The method for manufacturing the organic EL device according to the present embodiment includes forming the organic EL film 19 on the substrate 21 by, while supplying a strip-shaped substrate 21, successively vapor depositing at least an organic layer including the light-emitting layer 25a and a cathode layer (electrode layer) on one side of the substrate 21, and successively winding up the substrate 21 on which the organic EL film 19 has been formed. In this winding-up, the substrate 21 is wound up with the strip-shaped protective film 30, which is softer than the substrate 21, while further supplying the protective film 30 and adhering the protective film 30 to the non-vapor deposition side of the substrate 21.

Further, in the present embodiment, while supplying the substrate 21, which has the anode layer 23 (first electrode layer) formed on one side, the light-emitting layer 25a and the cathode layer 27 (second electrode layer), which has an opposite polarity to the anode layer 23, are successively vapor deposited on the anode layer 23. Alternatively, another method is to, while supplying a substrate on which the anode layer has not been formed in advance, form the anode layer on the substrate by a vapor deposition source for forming the anode layer, and then successively form the light-emitting layer 25a and the cathode layer 27 on the thus-formed anode layer.

In the present embodiment, specifically for example, first, the anode layer 23 is formed in advance on one side of the substrate 21 by sputtering or the like, and the substrate 21 wound up in a roll shape is fed from the substrate supply roller 5.

Next, while causing the non-vapor deposition side of the fed substrate 21 to contact with and move over the surface of the can roll 7, the light-emitting layer 25a as an organic layer is formed on the anode layer 23 on the substrate 21 supported on the can roll 7 by the first vapor deposition source 9a, and the cathode layer 27 is formed on the light-emitting layer 25a by the second vapor deposition source 9b, thereby form the organic EL film 19 on the substrate 21. Further, the substrate 21 is wound up by the wind-up roller 6 along with the protective film 30 while feeding the protective film 30 from the protective supply roller 8, and adhering the protective film 30 via the pressure-sensitive adhesive layer 30a to the non-vapor deposition side of the substrate 21 on which the organic EL film 19 has been formed.

Based on this manufacturing method, an organic EL device 20 can be manufactured in which an organic EL film 19 is formed on one side of a strip-shaped substrate 21, and a protective film 30 is adhered to and wound around the opposite side (non-vapor deposition side) to the organic EL film 19.

Further, according to this manufacturing method, by adhering the protective film 30 to the non-vapor deposition side of the substrate 21, misalignment of the protective film 30 with respect to the organic EL film 19 due to the protective film 30 being sandwiched between the non-vapor deposition side of the substrate 21 and the organic EL film 19 can be prevented. Consequently, damaging or scratching on the organic EL film 19 can be prevented by reducing rubbing between the protective film 30 and the organic EL film 19. Further, by using a protective film 30 that is softer than the substrate 21, even if a small amount of rubbing occurs between the organic EL film 19 and the protective film 30, damaging or scratching on the organic EL film 19 due to contact with the protective film 30 can be prevented. Therefore, the substrate 21 on which the organic EL film 19 has been formed can be wound up while preventing damaging or scratching on the organic EL film 19.

By preventing such damaging or scratching from occurring, the yield can be improved. Further, since the organic EL film 19 is formed on the substrate 21 and then the protective film 30 is made to contact with and adhere to the non-vapor deposition side of the substrate 21, the protective film 30 can be prevented from causing influences on formation of the light-emitting layer 25a and the cathode layer 27.

A sheet-shaped organic EL device 20 can be formed by feeding an organic EL device 20 wound up in the above-described manner by the wind-up roller 6, and cutting or the like. Specifically, it is possible to form an organic EL device 20 that includes an organic EL film 19, which has an anode layer 23, an organic layer including a light-emitting layer 25a as at least one layer, and a cathode layer 27 arranged on one side of a substrate 21, and a protective film 30, which is softer than the substrate 21, adhered to an opposite side (non-vapor deposition side) to the organic EL film 19, of the substrate 21. When the thus-formed organic EL device 20 is cut into a sheet shape, as described above, the organic EL device 20 wound up by the wind-up roller 6 is configured so that damaging or scratching on the organic EL film 19 is prevented, and hence, the organic EL device 20 formed in a sheet shape is also configured so that damaging or scratching on the organic EL film 19 is prevented.

Although the method for manufacturing an organic EL device, the manufacturing apparatus therefor, and the organic EL device according to the present invention are as described above, the present invention is not limited to the above-described embodiments, and may be appropriately changed within the scope intended by the present invention. For example, in the above-described embodiment, although the substrate supply roller 5 is arranged in the vacuum chamber 3, the substrate supply roller 5 may be arranged outside the vacuum chamber 3, as long as the substrate 21 can be fed to the can roll 7. Further, in the above-described embodiment, although the protective film feeder 8 and the recovery unit 6 are arranged in the vacuum chamber 3, the protective film feeder 8 and the recovery unit 6 may be arranged outside the vacuum chamber 3. as long as the substrate 21 that has been subjected to the vapor deposition process can be wound up while the protective film 30 is being adhered to the substrate 21 as described above.

Further, in the present embodiment, although the protective film 30 is configured having a pressure-sensitive adhesive layer 30a in order to adhere the protective film 30 to the non-vapor deposition side of the substrate 21, the method for adhering the protective film 30 to the substrate 21 is not especially limited to that described in the above embodiment. For example, the protective film 30 may be configured to have on one side a bonding-type adhesive layer that cannot be easily peeled off after being adhered to the substrate 21, so that the protective film 30 is adhered to the non-vapor deposition side of the substrate 21 via the bonding-type adhesive layer.

In addition, in the above-described embodiment, although a configuration was described in which the substrate 21 is wound up by the wind-up roller 6 with the side on which the organic EL film 19 is formed on the substrate 21 arranged on the external side and the non-vapor deposition side arranged on the inner side, the substrate 21 can also be wound up with the side on which the organic EL film 19 is formed on the substrate 21 arranged on the inner side and the non-vapor deposition side arranged on the external side.

### Examples

Next, the present invention will be described in more detail with reference to examples with no intention to limit the present invention to these examples.

### <Manufacturing of Organic EL device>

A manufacturing apparatus the same as the above-described manufacturing apparatus 1 for an organic EL device illustrated in FIG. 1 was used. Further, as the substrate, roll-shaped SUS 304 (50 mm width, 1,000 m length, 0.05 mm thickness) was used. Further, a 100 nm thick anode layer was formed in advance by coating an acrylic resin (JEM-477, manufactured by JSR Corporation) on one side of the substrate, drying and curing the coated resin to form (deposit) an insulating layer, and then sputtering IZO on the insulating layer.

On the other hand, as a protective film, as shown in Table 1, a film provided with a pressure-sensitive adhesive, which had a PET film and an acrylic pressure-sensitive adhesive layer on one side of the film, was used. Specifically, in Example 1, E-MASK TP₋300 (manufactured by Nitto Denko Corporation) was used, in Example 2, ELEP Masking ALS101 (manufactured by Nitto Denko Corporation) was used, and, in Example 3, the surface protective material SPV-364CK for decorative metal plates (manufactured by Nitto Denko Corporation) was used. The elastic modulus of these three types of pressure-sensitive adhesive film was as shown in Table 1, respectively Further, the thickness of all of these protective films, including the pressure-sensitive adhesive layer, was 60 µm.

Then, while supplying the substrate on which the anode layer was formed, an organic EL film was formed on the substrate by vapor depositing on the anode layer, in order, copper phthalocyanine (CuPc) to a thickness of 25 nm as a hole injection layer, α-NPD to a thickness of 45 nm as a hole transport layer, Alq3 to a thickness of 60 nm as a light-emitting layer, LiF to a thickness of 0.5 nm as an electron injection layer, and Al to a thickness of 10 nm as a cathode layer.

Then, the organic EL devices of Examples 1 to 3 were formed by, while adhering the protective film to the substrate by adhering the pressure-sensitive adhesive layer of each of the above-described three types of protective film to the non-vapor deposition side of the substrate on which the organic EL film was formed, winding up the substrate along with the protective film by the wind-up roller so that the non-vapor deposition side of the substrate was arranged on the external side and the vapor deposition side was arranged on the inner side.

On the other hand, the organic EL device of Comparative Example 1 was formed in the same manner as in Example 1, except that the substrate was wound up without using a protective film. Further, the organic EL device of Comparative Example 2 was formed in the same manner as in Example 1, except that the same roll-shaped SUS 304 as that of the substrate was used as the protective film, and the substrate was wound up along with the protective film by the wind-up roller while coating the protective film with a bonding-type acrylic adhesive and adhering the protective film to the non-vapor deposition side of the substrate with the bonding-type adhesive. In addition, the organic EL device of Comparative Example 3 was formed in the same manner as in Example 1, except that a PI film was used as the protective film, and the substrate was wound up along with the protective film simply by holding the protective film in contact with the non-vapor deposition side of the substrate, without forming a pressure-sensitive adhesive layer on the protective film and without adhering the protective film to the non-vapor deposition side of the substrate.

### <Evaluation Method>

The number of abrasion marks having a length of 100 µm or more on each of the wound-up organic EL devices of Examples 1 to 3 and Comparative Example 1 to 3 was measured using a light microscope (STM6-LM, manufactured by Olympus Corporation) by taking a total of 10 samples having 50 mm wide and 1 m long at 100 m intervals from the start of substrate wind up, and the average value of the abrasion marks in the 10 samples was calculated. Further, the presence of light emission in each sample was checked by applying an electric field between the anode layer and the cathode layer.

### <Evaluation Criteria>

Cases in which the abrasion mark average value was less than 3 were defined as a "○", cases in which the average value was 3 or more to less than 5 were defined as a "△", and cases in which the average value was 5 or more were defined as a "×". Further, regarding the presence of light emission, cases in which no more than 1 sample did not emit light over its whole surface were defined as a "○", cases in which more than 1 but no more than 3 samples did not emit light were defined as a "△", and cases in which more than 3 samples did not emit light were defined as a "×".

The evaluation results are shown in Table 1. As shown in Table 1, in Examples 1 to 3, which used a protective film having a smaller elastic modulus than the substrate and adhered the protective film to the substrate via a pressure-sensitive adhesive, there were few abrasion marks and light emission was good. In contrast, Comparative Example 1, which did not use a protective film, Comparative Example 2, which used a protective film having a larger elastic modulus than the substrate, and Comparative Example 3, which although it used a protective film having a smaller elastic modulus than the substrate, did not adhere the protective film to the substrate, all had a large number of abrasion marks and poor light emission.

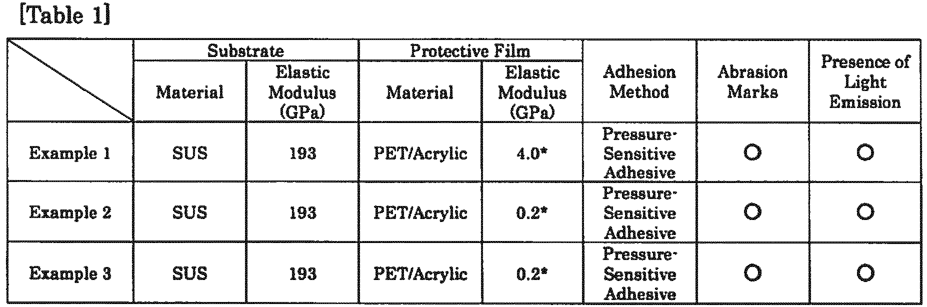

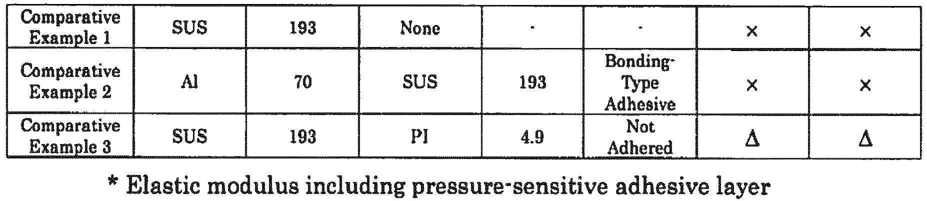

It was learned from the above results that damaging or scratching on an organic EL film can be prevented by the method for manufacturing an organic EL device and the manufacturing apparatus for an organic EL device according to the present invention.

### Description of the Reference Numerals

1: Manufacturing apparatus for organic EL device, 5: Substrate feeder, 6: Recovery unit (recovery part), 7: Can roll, 8: Protective film feeder (protective supply part), 9: Vapor deposition source (vapor deposition part), 9a: First vapor deposition source, 9b: Second vapor deposition source, 19: Organic EL film, 20: Organic EL device, 21: Substrate, 23: Anode layer (first electrode layer), 25a: Light-emitting layer (organic structural layer, organic layer), 27: cathode layer (second electrode layer), 30: Protective film, 30a: Pressure-sensitive adhesive layer

## Claims

1. A method for manufacturing an organic EL device, comprising:
while supplying a strip-shaped substrate, forming an organic EL film on the substrate by successively vapor depositing at least an organic layer including a light-emitting layer and an electrode layer on one side of the substrate; and
successively winding up the substrate on which the organic EL film is formed by the vapor deposition, wherein
the substrate is wound up along with a strip-shaped protective film that is softer than the substrate while supplying the protective film and adhering the protective film to a non-vapor deposition side of the substrate.

2. The method for manufacturing an organic EL device according to claim 1, wherein, while supplying the substrate on which a first electrode layer is formed on one side, the organic layer and a second electrode layer which has an opposite polarity to the first electrode layer are successively vapor deposited on the first electrode layer.

3. The method for manufacturing an organic EL device according to any one of claims 1 and 2, wherein the protective film has an elastic modulus of 4.2 GPa or less.

4. The method for manufacturing an organic EL device according to any one of claims 1 to 3, wherein the substrate is formed from a metal material.

5. The method for manufacturing an organic EL device according to any one of claims 1 to 4, wherein the protective film comprises on one side a pressure-sensitive adhesive layer that allows the protective film to be adhered to and peeled from the substrate, and
the protective film is adhered to a non-vapor deposition side of the substrate via the pressure-sensitive adhesive layer.

6. A manufacturing apparatus for an organic EL device, comprising:
a vapor deposition part for, while a strip-shaped substrate is supplied, forming an organic EL film on the substrate by successively vapor depositing at least an organic layer including a light-emitting layer and an electrode layer on one side of the substrate;
a recovery part for successively winding up the substrate on which the organic EL film is formed by the vapor deposition part; and
a protective film supply part for supplying a strip-shaped protective film that is softer than the substrate, wherein
the recovery part is configured to wind up the substrate and the protective film while the protective film supplied from the protective film supply part is adhered to a non-vapor deposition side of the substrate.

7. The manufacturing apparatus for an organic EL device according to claim 6, wherein the vapor deposition part is configured to, while the substrate on which a first electrode layer is formed on one side is supplied, successively vapor deposit on the first electrode layer the organic layer and a second electrode layer which has an opposite polarity to the first electrode layer.

8. An organic EL device comprising:
a substrate;
an organic EL film provided on one side of the substrate, the organic EL film comprising a first electrode layer, an organic layer including a light-emitting layer, and a second electrode layer which has an opposite polarity to the first electrode layer; and
a protective film that is adhered to an opposite side to the organic EL film on the substrate and that is softer than the substrate.

9. A method for manufacturing an organic EL device comprising the steps of:
supplying a substrate which has a strip-shape;
forming an organic EL film on the substrate by successively vapor depositing an organic layer including a light-emitting layer and an electrode layer on one side of the substrate;
supplying a protective film which has a strip-shape and is softer than the substrate;
adhering the protective film to a non-vapor deposition side of the substrate; and
winding up the substrate to which the protective film has been adhered.
